# EUROPÄISCHE PATENTANMELDUNG

(11) **EP 3 680 361 A1**
(43) Veröffentlichungstag der Anmeldung: **15.07.2020**
(21) Anmeldenummer: 19150981.9
(22) Anmeldetag: 09.01.2019
(51) Int. Cl.: C23C 4/134, C23C 16/453, C23C 16/40, B05B 7/22, H05H 1/42

(54) **AUFSATZ ZUM DOSIEREN EINES PRECURSORS UND VERFAHREN ZUR HERSTELLUNG EINER SCHICHT**

(71) Anmelder: Innovent e.V., 07745 Jena (DE)
(72) Erfinder: GERULLIS, Sven, 07768 Kahla (DE); BEIER, Oliver, 07407 Rudolstadt (DE); PFUCH, Dr. Andreas, 99510 Apolda (DE); MARTIN, Björn, 07745 Jena (DE); GRÜNLER, Dr. Bernd, 07937 Zeulenroda-Triebes (DE)
(74) Vertreter: Liedtke & Partner Patentanwälte

(57) **Zusammenfassung**

Die Erfindung betrifft einen Aufsatz (1) für eine Plasmaquelle (2) zur Dosierung von Precursoren, umfassend mindestens eine Düse (5), die an der Plasmaquelle (2) befestigt oder anderweitig in einer festen Position zur Plasmaquelle (2) anordenbar ist, derart, dass ein aus der Düse (5) ausströmender Precursor einem aus der Plasmaquelle (2) austretenden Plasmastrahl unter einem vorgegebenen Winkel (ω) sowie mit einem in einem Bereich von 0,5 mm bis 10 mm einstellbaren vorgegebenen Abstand (b) zwischen einer Austrittsöffnung der Düse (5) und einem zu beschichtenden Substrat (4) zuführbar ist. Die Erfindung betrifft ferner ein Verfahren zur Herstellung einer Schicht auf einem Substrat (4), wobei in der Nähe des Substrats (4) mindestens ein Precursor über den Aufsatz (1) in oder in die Nähe eines aus einer Plasmaquelle (2) austretenden Plasmastromes eindosiert wird.

## Beschreibung

Die Erfindung betrifft einen Aufsatz zum Dosieren eines Precursors und ein Verfahren zur Abscheidung einer Schicht oder einer Mischschicht.

Die Herstellung und Nutzung von Mischschichten ist bekannt.

Vor allem Prozesse der physikalischen Dampfphasenabscheidung (PVD) wie beispielsweise thermisches Verdampfen [Gaffney, A. M., et al. "Characterization and catalytic studies of PVD synthesized Mo/V/Nb/Te oxide catalysts." Journal of Catalysis 229.1 (2005): 12-23.] oder Sputtern [Hovsepian, P. Eh, A. P. Ehiasarian, and U. Ratayski. "CrAlYCN/CrCN nanoscale multilayer PVD coatings deposited by the combined high power impulse magnetron sputtering/unbalanced magnetron sputtering (HIPIMS/UBM) technology." Surface and coatings technology 203.9 (2009): 1237-1243.] werden zur Herstellung von Mischoxidschichten beschrieben. In der Regel wird für solche Verfahren allerdings eine entsprechende Vakuum- und Anlagentechnik benötigt, welche mit zusätzlichen Kosten verbunden ist.

Mischschichten lassen sich auch unter Normaldruckbedingungen herstellen. Vor allem thermische CVD (chemical vapour deposition) wie die APCVD (Atmospheric Pressure Chemical Vapour Deposition) wären in diesem Zusammenhang zu nennen. Die für die chemische Umsetzung der Precursoren benötigte Energie wird bei dieser Methode häufig durch das Beheizen des Substratmaterials bereitgestellt. So können Substrattemperaturen von 200 °C bis 700 °C [Wang, H. B., et al. "Deposition and characterization of YSZ thin films by aerosol-assisted CVD." Materials Letters 44.1 (2000): 23-28.; Gesheva, K. A., et al. "Crystallization of chemically vapor deposited molybdenum and mixed tungsten/molybdenum oxide films for electrochromic application." Thin Solid Films 515.11 (2007): 4609-4613.; Bodurov, Georgi, et al. "Thin film optical coatings of Vanadium Oxide and mixed Tungsten/Vanadium Oxide deposited by APCVD employing precursors of Vanadyl Acetylacetonate and a mixture with tungsten hexacarbonyl." Physics Procedia 46 (2013): 127-136.] notwendig werden. Diese Tatsache schließt somit die Beschichtung temperaturempfindlicher Substrate wie Kunststoffe aus.

Eine weitere Methode zur Erzeugung dünner Mischoxidschichten ist die Sol-Gel-Technik [Galatsis, Kosmas, et al. "Comparison of single and binary oxide MoO3, TiO2 and WO3 sol-gel gas sensors." Sensors and Actuators B: Chemical 83.1 (2002): 276-280.; Rampaul, Ashti, et al. "Titania and tungsten doped titania thin films on glass; active photocatalysts." Polyhedron 22.1 (2003): 35-44.]. Beim Sol-Gel-Prozess handelt es sich um ein nasschemisches Beschichtungsverfahren, wobei in der Regel ein anschließender Nachbehandlungsschritt (Trocknen, Wärmebehandlung, UV-Aushärtung) der Schichten notwendig wird. Die nasschemische Abscheidung und/oder die Nachbehandlung können bei der Wahl des Substratmaterials ebenfalls limitierende Faktoren sein.

Mischoxide bzw. Mischoxiddünnschichten oder Mischschichten allgemein können in einer Vielzahl von Bereichen Anwendung finden. Zu nennen wären hier Katalysatorschichten (Mo/V/Nb/Te-Oxide [Gaffney, A. M., et al. "Characterization and catalytic studies of PVD synthesized Mo/V/Nb/Te oxide catalysts." Journal of Catalysis 229.1 (2005): 12-23.]), Verschleißschutzschichten [Hovsepian, P. Eh, A. P. Ehiasarian, and U. Ratayski. "CrAlYCN/CrCN nanoscale multilayer PVD coatings deposited by the combined high power impulse magnetron sputtering/unbalanced magnetron sputtering (HIPIMS/UBM) technology." Surface and coatings technology 203.9 (2009): 1237-1243.], ionenleitende Schichten (YSZ [Wang, H. B., et al. "Deposition and characterization of YSZ thin films by aerosol-assisted CVD." Materials Letters 44.1 (2000): 23-28.]), elektrochrome Schichten u.a. für schaltbare Gläser (MoOₓ, MoWOₓ [Gesheva, K. A., et al. "Crystallization of chemically vapor deposited molybdenum and mixed tungsten/molybdenum oxide films for electrochromic application." Thin Solid Films 515.11 (2007): 4609-4613.]), Schichten für Spintronikanwendungen (z. B. Y₃Fe₅O₁₂ - Yttrium Eisen Granat YIG [Dubs, Carsten, et al. "Sub-micrometer yttrium iron garnet LPE films with low ferromagnetic resonance losses." J. Phys. D: Appl. Phys. 50 (2017), https://doi.org/10.1088/1361-6463/aa6b1c]) oder photokatalytisch aktive Beschichtungen (TiOₓ, TiWOₓ [Rampaul, Ashti, et al. "Titania and tungsten doped titania thin films on glass; active photocatalysts." Polyhedron 22.1 (2003): 35-44.]). Darüber hinaus kann die Aufwachsrate von Schichten erhöht werden [Bodurov, Georgi, et al. "Thin film optical coatings of Vanadium Oxide and mixed Tungsten/Vanadium Oxide deposited by APCVD employing precursors of Vanadyl Acetylacetonate and a mixture with tungsten hexacarbonyl." Physics Procedia 46 (2013): 127-136.]. Dabei wurden bei der Herstellung von WO₃ zu dem Precursor W(CO)₆ zusätzlich V(CO)₆ oder Vanadium acetylacetonate mit dem Ziel eingebracht, Schichtwachstumsraten zu erhöhen und damit den Beschichtungsprozess wirtschaftlicher zu gestalten. In diesem Beispiel wurde ein APCVD-Beschichtungsprozess zur Abscheidung der Schichten verwendet (Beheizen der Substrate auf 400-500 °C und Beheizen der Gasströme zum Precursortransport auf ∼170 °C notwendig). Weitere Anwendungsgebiete von MischoxidSchichten wären die Batterietechnik [Davari, Elaheh, et al. "Manganese-cobalt mixed oxide film as a bifunctional catalyst for rechargeable zinc-air batteries." Electrochimica Acta 211 (2016): 735-743.], hier werden u.a. Verfahren wie Elektrodeposition (Elektroplating) angewandt, wobei es sich hier um eine elektrochemische Beschichtungsmethode handelt.

Titandioxid wird in einer Vielzahl von Anwendungen eingesetzt. Zu nennen wären Anwendungen im Bereich UV-Schutz, photokatalytisch aktive Schichten (z. B. selbstreinigende Oberflächen) oder Katalysatoren und z.T. antimikrobielle Anwendungen. Titandioxid in Form von Nanopartikeln ist vor allem aufgrund der hohen spezifischen Oberfläche interessant [Wei, Xiaojin, et al. "Photocatalytic TiO2 nanoparticles enhanced polymer antimicrobial coating." Applied Surface Science 290 (2014): 274-279.]. Für viele Anwendungen ist TiO₂ immobilisiert in Form von Schichten allerdings vorteilhafter. Herkömmliche Verfahren zur Erzeugung von TiO₂-Dünnschichten sind physikalische Dampfphasenabscheidung (PVD) wie Sputtern [Tang, H., et al. "Electrical and optical properties of TiO2 anatase thin films." Journal of Applied Physics 75.4 (1994): 2042-2047.; Tölke, Tina, et al. "The influence of pressure on the structure and the self-cleaning properties of sputter deposited TiO2 layers." Thin Solid Films 518 (2010), 4242-4246], Sol-Gel [Yu, Jiaguo, et al. "Preparation, microstructure and photocatalytic activity of the porous TiO2 anatase coating by sol-gel processing." Journal of sol-gel Science and Technology 17.2 (2000): 163-171] oder chemische Dampfphasenabscheidung (CVD) [Richards, B. S., N. T. P. Huong, and A. Crosky. "Highly porous nanocluster TiO2 films deposited using APCVD in an excess of water vapor." Journal of The Electrochemical Society 152.7 (2005): F71-F74.]. CVD Prozesse haben allerdings den Nachteil, dass die Substrate während der Beschichtung häufig geheizt (∼250 °C [Jung, Sang-Chul, and Nobuyuki Imaishi. "Preparation, crystal structure, and photocatalytic activity of TiO2 films by chemical vapor deposition." Korean Journal of Chemical Engineering 18.6 (2001): 867-872.]) werden müssen, um photokatalytisch aktive Schichten zu erzeugen. Eine thermische Nachbehandlung (∼450 °C [Mills, Andrew, et al. "Photocatalytic oxidation of deposited sulfur and gaseous sulfur dioxide by TiO2 films." The Journal of Physical Chemistry C 111.14 (2007): 5520-5525.]) wird hingegen bei Sol-Gel Prozessen oftmals notwendig. Derartige Methoden sind für die Beschichtung temperaturempfindlicher Substrate entsprechend ungeeignet. In der Literatur sind allerdings auch Sol-Gel Methoden bekannt, welche bei deutlich niedrigeren Substrat- oder Nachbehandlungstemperaturen (∼100 °C [Langlet, M., et al. "Sol-gel preparation of photocatalytic TiO2 films on polymer substrates." Journal of sol-gel science and technology 25.3 (2002): 223-234.], 120 °C [Yun, Young Jin, et al. "Lowtemperature coating of sol-gel anatase thin films." Materials Letters 58.29 (2004): 3703-3706.]) photokatalytisch aktive Schichten erzeugen. Jedoch beinhalten diese Ansätze mehrere und oft zeitraubende Arbeitsschritte (z. B. achtstündige Temperaturbehandlung des Sols).

Vor diesem Hintergrund könnten plasmabasierte Prozesse, welche Schichten mit ähnlichen Eigenschaftsspektren in nur einem Arbeitsschritt ermöglichen, von Interesse sein. Plasma-enhanced CVD (PECVD) Prozesse wurden in diesem Zusammenhang in der Literatur untersucht. Neben Prozessen, die im Vakuum arbeiten, existieren auch Methoden, die unter Atmosphärendruckbedingungen eine Schichtherstellung ermöglichen. Eine Möglichkeit wäre der Einsatz von DBD-Quellen. So wurde in der Literatur die Herstellung von TiOₓ-Schichten unter dem Einsatz von TiCl₄ beschrieben, die nanokristalline Bestandteile enthalten [Xu S., J. Xu, X. Peng, J. Zhang, Plasma Sci. Technol. 8 (1999) 292.; Zhu, A - M., et al. "Crystalline, Uniform - Sized TiO2 Nanosphere Films by a Novel Plasma CVD Process at Atmospheric Pressure and Room Temperature." Chemical Vapor Deposition 13.4 (2007): 141-144.].

Der Erfindung liegt die Aufgabe zu Grunde, einen Aufsatz zum Dosieren eines Precursors und ein verbessertes Verfahren zur Abscheidung einer Schicht anzugeben.

Die Aufgabe wird erfindungsgemäß gelöst durch einen Aufsatz zum Dosieren eines Precursors und ein Verfahren zur Abscheidung einer Schicht.

Vorteilhafte Ausgestaltungen der Erfindung sind Gegenstand der Unteransprüche.

Ein erfindungsgemäßer Aufsatz für eine Plasmaquelle zur Dosierung von Precursoren umfasst mindestens eine Düse, die an der Plasmaquelle befestigt oder anderweitig in einer festen Position zur Plasmaquelle anordenbar ist, derart, dass ein aus der Düse ausströmender Precursor einem aus der Plasmaquelle austretenden Plasmastrahl unter einem vorgegebenen Winkel sowie mit einem in einem Bereich von 0,5 mm bis 10 mm einstellbaren vorgegebenen Abstand zwischen einer Austrittsöffnung der Düse und einem zu beschichtenden Substrat zuführbar ist.

In einer Ausführungsform ist ein Abstand zwischen einer Austrittsöffnung der Plasmaquelle und dem Substrat und/oder der Winkel einstellbar.

In einer Ausführungsform sind mindestens zwei Düsen vorgesehen.

In einer Ausführungsform sind die mindestens zwei Düsen unabhängig voneinander bezüglich des Abstands und/oder des Winkels einstellbar.

Bei einem erfindungsgemäßen Verfahren zur Herstellung einer Schicht auf einem Substrat wird in der Nähe des Substrats mindestens ein Precursor über einen Aufsatz wie oben beschrieben in oder in die Nähe eines aus einer Plasmaquelle austretenden Plasmastromes eindosiert. In die Nähe bedeutet hier, dass der Precursor nicht direkt mit dem Plasmastrom interagieren muss. Das ist zum Beispiel der Fall, wenn der Abstand zwischen der Austrittsöffnung der Plasmaquelle und dem Substrat besonders groß gewählt ist und der Abstand zwischen der Austrittsöffnung der Düse und dem Substrat sehr klein. Denkbar wäre auch, den Precursor außermittig zum Plasmastrom einzudosieren.

In einer Ausführungsform wird eine Oxidschicht, eine Nitridschicht, eine Carbidschicht, eine Phosphatschicht, eine Polymerschicht, oder durch Eindosieren mehrerer Precursoren in oder in die Nähe des Plasmastroms eine Metalloxid-Mischschicht, eine Metalloxid/Halbleiteroxid-Mischschicht, eine Metalloxid/Nichtmetalloxid-Mischschicht, eine Halbleiteroxid/Nichtmetalloxid-Mischschicht, eine Polymer-Mischschicht, eine Metalloxid/Polymer-Mischschicht, eine Halbleiteroxid/Polymer-Mischschicht oder eine Kompositschicht bestehend aus einer Matrixschicht, die mit Partikeln beladen ist, abgeschieden.

In einer Ausführungsform werden die Precursoren dem Aufsatz in Form eines Gases oder Gasgemisches, als Aerosol oder in Feststoffform, beispielsweise als Pulver, zugeführt.

In einer Ausführungsform wird mittels des Aufsatzes ein Abstand zwischen einer Austrittsöffnung der Düse und einem zu beschichtenden Substrat in einem Bereich von 0,5 mm bis 10 mm eingestellt.

In einer Ausführungsform wird Luft oder Stickstoff als Arbeitsgas für die Plasmaquelle verwendet.

In einer Ausführungsform erfolgen eine Temperierung des Substrates während des Beschichtungsprozesses und/oder eine anschließende Wärmebehandlung.

In einer alternativen Ausführungsform unterbleiben eine Temperierung des Substrates während des Beschichtungsprozesses und/oder eine anschließende Wärmebehandlung.

Die Erfindung betrifft weiter ein Bauteil, umfassend eine Oberfläche, die mittels des oben beschriebenen Verfahrens mit einer photokatalytisch aktiven TiOₓ - Schicht oder SiOₓ / TiOₓ-Mischschicht beschichtet ist.

Ferner betrifft die Erfindung ein Bauteil, umfassend eine Oberfläche, die mittels des oben beschriebenen Verfahrens mit einer Yttrium-Eisen-Granat oder Yttrium-Aluminum-Granat oder SnOₓ - Schicht oder SiOₓ - Schicht oder SiOₓ / SnOₓ - Mischschicht beschichtet ist.

Weiter betrifft die Erfindung ein Bauteil, umfassend eine Oberfläche, die mittels des oben beschriebenen Verfahrens mit einer optisch transparenten SiOₓ / TiOₓ oder SiOₓ / SnOₓ Mischschicht beschichtet ist, wobei eine Brechzahl oder ein Brechzahlgradient über die Schichtdicke durch Variation des Mischungsverhältnisses zweier eindosierter Precursoren gezielt einstellbar ist.

Die erfindungsgemäß verwendeten Plasma-Jets haben im Vergleich zu herkömmlichen Beschichtungsprozessen den Vorteil, dass Oberflächenbereiche auch selektiv behandelbar sind. Das Erhitzen und/oder Verdampfen der Precursoren ist nicht zwingend notwendig. Stattdessen werden die Precursoren in Aerosolform zugeführt. Somit ist auch kein Aufheizen von Schläuchen notwendig, um ein Auskondensieren des Precursors zu vermeiden.

Es wurde ein neuer Aufsatz für Plasmadüsen entwickelt, mit dem gezielt die Einspeisepunkte des Precursors in das Plasma eingestellt werden können. Dabei zeigte sich überraschenderweise, dass gezielt Mischschichten (Schichten bestehend aus mehreren Metalloxiden, beispielsweise Siliciumoxid und Titanoxid) durch gleichzeitiges Einbringen verschiedener Precursoren hergestellt werden können. Solche Schichten zeigen unter anderem die Möglichkeit auf, durch Variation des Mischungsverhältnisses diverse Schichteigenschaften (Brechzahl, photokatalytische Aktivität, Transmission, antimikrobielle Aktivität) gezielt einzustellen, ohne dass eine Temperierung des Substrates während des Beschichtungsprozesses oder eine anschließende Wärmebehandlung (oft 400 °C bis 500 °C) notwendig ist.

Aufgrund dessen ist auch erstmalig die Beschichtung temperaturempfindlicher Substrate (beispielsweise Kunststoffe, Holz, WPC, Verbundwerkstoffe, Fasern,

Textilien, Farben oder lackierte Oberflächen) möglich, vor allem zur Abscheidung photokatalytisch aktiver Schichten. Weiterhin bietet der Aufsatz den Vorteil, dass eine Verschmutzung der Plasmadüsen nicht stattfindet, im Gegensatz zur Einspeisung des Precursors direkt durch die Plasmadüse (sogenannter direct mode). Somit wird ein langzeitstabiler Plasma- und Beschichtungsprozess ermöglicht, und auf Reinigungsschritte der Plasmadüsen kann verzichtet werden.

Insbesondere erfolgt die Abscheidung bei Atmosphärendruck.

Ausführungsbeispiele der Erfindung werden im Folgenden anhand von Zeichnungen näher erläutert.

Darin zeigen:
- Figur 1: eine schematische Ansicht eines Aufsatzes für eine Plasmaquelle zur Dosierung von Precursoren,
- Figur 2: eine schematische Ansicht der Plasmaquelle und des Aufsatzes, wobei die Düse verstellbar an der Plasmaquelle angeordnet ist,
- Figur 3: eine schematische Ansicht der Plasmaquelle und des Aufsatzes mit zwei Düsen,
- Figur 4: eine schematische Ansicht einer weiteren Ausführungsform einer Plasmaquelle mit linienförmigem Plasma und eines Aufsatzes zur Dosierung von Precursoren,
- Figur 5: ein Diagramm mit einer Elementkonzentration in Abhängigkeit von einer Dosiermenge eines titanhaltigen Precursors,
- Figur 6: FTIR-Spektren von SiOₓ / TiOₓ Mischschichten und reinen SiOₓ und TiOₓ Plasmaschichten,
- Figur 7: ellipsometrisch ermittelte Brechzahlen von Schichten in Abhängigkeit von einer Dosierrate für SiOₓ / TiOₓ Mischschichten und reine SiOₓ und TiOₓ Plasmaschichten,
- Figur 8: relative Bandenflächen aus FTIR-Messungen in Abhängigkeit von einer Bestrahlungszeit für SiOₓ / TiOₓ Mischschichten und reine SiOₓ und TiOₓ Plasmaschichten,
- Figur 9: eine Schichtzusammensetzung in Abhängigkeit vom Precursorfluss für SiOₓ / SnO Mischschichten und reine SiOₓ und SnO Plasmaschichten,
- Figur 10: UV/VIS-Spektren von Schichten in Transmission für SiOₓ / SnO Mischschichten und reine SiOₓ und SnO Plasmaschichten,
- Figur 11: UV/VIS-Spektren von Schichten in Transmission für TiOₓ Plasma schichten,
- Figur 12: eine Bandlückenbestimmung für TiOₓ Plasmaschichten,

- Figur 13: relative Bandenflächen aus FTIR-Messungen in Abhängigkeit von einer Bestrahlungszeit für TiOₓ Plasmaschichten und Referenzproben,
- Figur 14: die Schichtdicke in Abhängigkeit von der Anzahl der Durchläufe der Beschichtung für SiOₓ Plasmaschichten, und
- Figur 15: der Schichtdickenverlust nach abrasiver Beanspruchung in Abhängigkeit von der Anzahl der Durchläufe der SiOₓ Beschichtung.

Einander entsprechende Teile sind in allen Figuren mit den gleichen Bezugszeichen versehen.

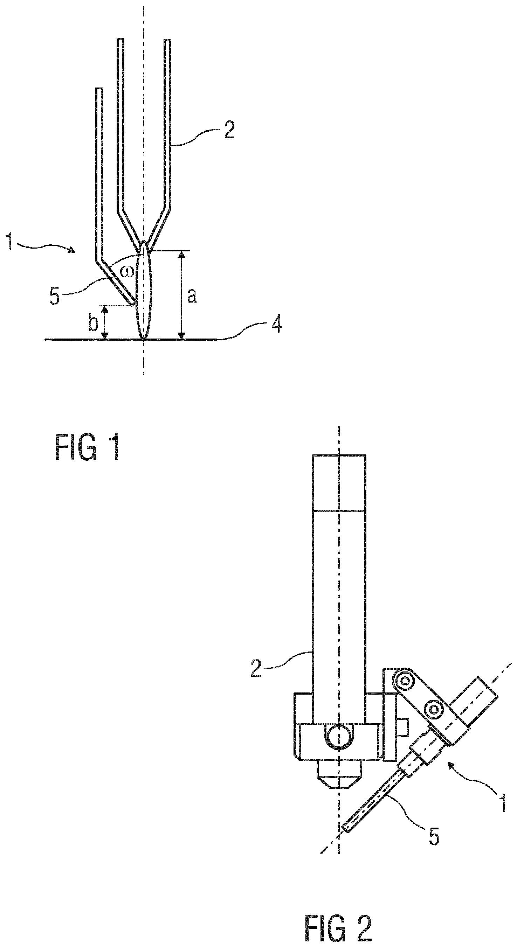

**Figur 1** zeigt eine schematische Ansicht eines Aufsatzes 1 für eine Plasmaquelle 2 zur Dosierung von Precursoren.

In Vorversuchen hat sich gezeigt, dass es für viele Precursoren vorteilhaft ist, deren Interaktionzeit im Plasma auf ein notwendiges Minimum zu reduzieren. Lange Verweildauern der Precursoren im Plasma können beispielsweise zu übermäßiger Partikelbildung und Agglomeration führen, was die Bildung qualitativ schlechterer Schichten, beispielsweise in Hinblick auf Abrasionsstabilität, bewirken kann. Um die Interaktionszeit auf ein notwendiges Maß zu reduzieren, wurde ein Aufsatz 1 entwickelt und gefertigt. Der Aufsatz 1 umfasst mindestens eine Düse 5, die an der Plasmaquelle 2 befestigt oder anderweitig in einer festen Position zur Plasmaquelle 2 anordenbar ist, derart, dass ein aus der Düse 5 ausströmender Precursor einem aus der Plasmaquelle 2 ausgetretenen Plasmastrahl unter einem Winkel ω zuführbar ist. Dieser Winkel ω sowie ein Abstand b zwischen einer Austrittsöffnung der Düse 5 und einem Substrat 4 und einem Abstand a zwischen einer Austrittsöffnung der Plasmaquelle 2 und dem Substrat 4 können einstellbar sein.

**Figur 2** ist eine schematische Ansicht der Plasmaquelle 2 und des Aufsatzes 1, wobei die Düse 5 verstellbar an der Plasmaquelle 2 angeordnet ist.

Mit Hilfe dieses Aufsatzes 1 können Precursoren in Form von Aerosol-Tröpfchen und/oder gasförmig, beispielsweise in einem Abstand b von etwa 0,5 mm bis 10 mm und unter einem einstellbaren Winkel ω, von 0° bis 90°, besonders bevorzugt zwischen 0° und 60° (beispielsweise von 45°), zum Plasmastrahl durch die Düse 5, (beispielsweise mit einem Innendurchmesser von 2 mm, Edelstahl) in den Plasmastrahl eingebracht werden.

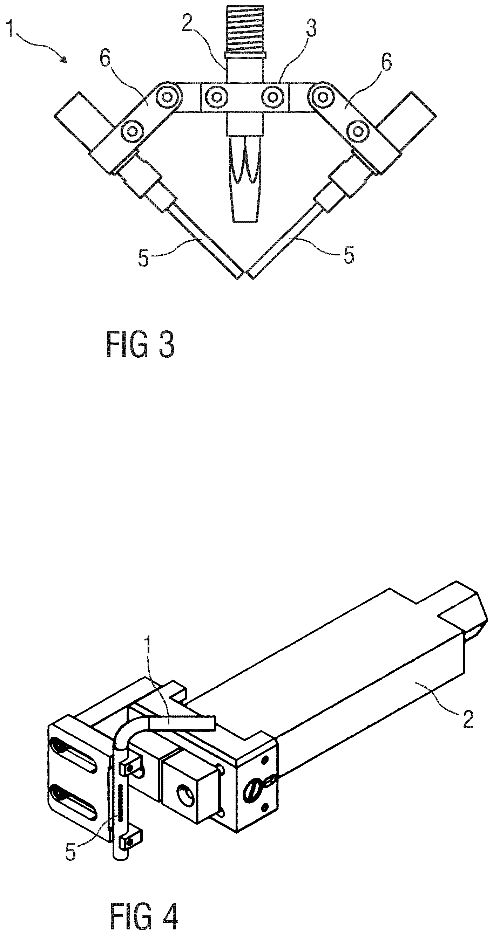

In einem Ausführungsbeispiel kann der Aufsatz 1 mehrere Düsen 5 umfassen. **Figur 3** ist eine schematische Ansicht der Plasmaquelle 2 und des Aufsatzes 1 mit zwei Düsen 5, von denen jede verstellbar an der Plasmaquelle 2 angeordnet ist, beispielsweise mittels einer Schelle 3 und schwenkbaren Armen 6. Somit kann über eine variable Anzahl an Düsen 5 die Anzahl von Precursoren je nach Anforderung an die Beschichtung gewählt werden.

In Ausführungsbeispielen von Verfahren zur Erzeugung von binären Mischschichten wurden zwei Düsen 5 verwendet. Weiterhin bietet dieses System konstruktiv die Möglichkeit, eine variable Anzahl n von Düsen 5 und damit eine variable Anzahl von Precursoren einzubringen, was die Möglichkeit zur Bildung noch komplexerer Schichtsysteme ermöglicht.

Ein weiterer Vorteil dieser Ausführung ist die Möglichkeit, den Abstand b unabhängig vom Abstand a zwischen einer Austrittsöffnung der Plasmaquelle 2 und dem Substrat 4 zu verändern. Somit kann zum einen der Abstand a verändert werden, um den thermischen Einfluss des Plasmas auf das Substrat 4 gezielt einzustellen und gegebenenfalls zu minimieren. Und zum anderen kann der Abstand b so angepasst werden, dass die für die Umsetzung des Precursors und Schichtbildung notwendige Interaktionszeit im Plasma gegeben ist, aber übermäßiger Energieeintrag in den Precursor vermieden werden kann. Auch können zur Abscheidung von Mischschichten 1 + n Düsen verwendet und deren jeweiliger Abstand b unabhängig von den Abständen b der anderen Düsen angepasst werden. Somit können die Abstände b1 (für Düse 1), b2 (für Düse 2), usw. gezielt an die jeweilige Precursorsubstanz optimal angepasst (Plasma-Precursor Interaktionszeit) werden, für die Schichtumsetzung.

**Figur 4** zeigt eine schematische Ansicht einer weiteren Ausführungsform einer Plasmaquelle 2 mit linienförmigem Plasma und eines darauf angepassten Aufsatzes 1.

In Figur 4 ist die Plasmaquelle 2 dargestellt, wobei das linienförmige Plasma aus dem Schlitz unterhalt der Quelle austritt. In diesem Ausführungsbeispiel enthält der Aufsatz 1 ein Rohr mit einer auf die Breite des Plasmas angepassten Anordnung von Austrittsöffnungen (Düse 5), durch welche der Precursor in das Plasma eingebracht wird. Dabei sind analog zur Figur 1 die Abstände a, b und der Winkel ω variabel einstellbar.

In Tabelle 1 werden mögliche variable Beschichtungsparameter dargestellt.

**Tabelle 1: Prozessparameter Mischschichten**

| **Prozessparameter** | **Einheit** | **Einstellbereich** |
|---|---|---|
| Plasmaleistung | [W] | 50 bis 600 |
| Arbeitsgas | [-] | Stickstoff, (Luft) |
| Verfahrgeschwindigkeit | [mm/s] | 1 bis 300 |
| Anzahl Durchläufe | [-] | 1 bis 100 |
| Abstand a | [mm] | 5 bis 40 |
| Abstand b | [mm] | 0,5 bis 10 |

| **Parameter Precursordosierung** | | |
|---|---|---|
| Precursorkonzentration (Flüssigprecursor → Aerosoldosiersystem) | [Gew.-%] | 0 bis 100 |
| Precursorfluss Mikrodosierpumpe (Flüssigprecursor → Aerosoldosiersystem) | [µl/min] | 5 bis 200 |
| Zweistoffdüsendruck (Aerosoldosiersystem) | [bar] | 1 bis 6 |
| Precursorfluss siliziumorganischer Precursor (Hexamethyldisiloxan → Verdampfereinheit) | [ml/min] | 1 bis 25 |

Zur Schichtabscheidung wurde eine Plasmaquelle 2 CAT (curved arc technology) 600 (W) der Firma Tigres GmbH (Marschacht, Deutschland) verwendet. Diese Plasmaquelle arbeitet bei Leistungen zwischen 50 und 600 W, wobei für die meisten der vorstehend aufgeführten Untersuchungen Leistungen von 600 W verwendet wurden. Diese Plasmaquelle 2 kann unter anderem mit den Arbeitsgasen Luft, Stickstoff und Argon betrieben werden, wobei die Schichtqualität in Hinblick auf Abrasionsbeständigkeit und optischer Güte bei Verwendung von Stickstoff am besten war. Demzufolge wurden die meisten der durchgeführten Experimente mit Stickstoff durchgeführt. Alternativ können aber auch andere Plasmasysteme, vorzugsweise Jet-Plasmaquellen und/oder andere Arbeitsgase verwendet werden. Precursoren können zum einen als Aerosol über ein Aerosoldosiersystem (wie in der EP 2 743 373 B1 beschrieben) in Kombination mit einer Zweistoffdüse und einer Mikrodosierpumpe dem Plasma bereitgestellt werden. Dabei werden die Flüssigprecursoren durch die Mikrodosierpumpe mit Flussraten typischerweise von 5 bis 200 µl/min in Schläuchen zu der Zweistoffdüse gefördert. Die Zweistoffdüse wird mit Gasdrücken von 1 bis 6 bar betrieben und so der Flüssigprecursor zu einem Aerosol zerstäubt, wobei die Gasart wie das Arbeitsgas der Plasmaquelle gewählt werden oder auch verschieden sein kann. Durch das Aerosoldosiersystem kann eine Separation und Limitierung der maximalen Tröpfengrößen realisiert werden und das Aerosol gelangt anschließend durch die Düsen 5 des Aufsatzes 1 in die Plasmazone und/oder zum Substrat. Aufgrund des Aerosoldosiersystems wird ein sehr homogenes Beschichtungsbild erhalten.

Zum anderen können Precursoren (z. B. Hexamethyldisiloxan) in gasförmiger Form eingebracht werden. In den dargestellten Beispielen (I, II und IV) wurden Precursoren über die Verdampfereinheit STS 10.0 der Firma Sura Instruments GmbH direkt durch die Dosierdüsen eingebracht. Gasflüsse von 1 bis 25 ml/min können mit diesem System erreicht werden. Die Zudosierung ist aber nicht auf gasförmige Precursoren oder Flüssigprecursoren beschränkt. Alternativ können beispielsweise Nanopartikel-Dispersionen oder Pulver verwendet und dem Plasma zugeführt werden, über den Aufsatz 1.

### Beispiel I (SiOₓ / TiOₓ-Mischschichten)

In einem Ausführungsbeispiel wurden zur Abscheidung des titanhaltigen-Schichtbestandteils die Precursoren TTIP (Titan (IV) Isopropoxid, 97%, Sigma Aldrich), TBO (Titan (IV) Butoxid, 97%, Sigma Aldrich) und TIPO (Titan (IV) Diisopropoxid bis(acetylacetonate), 75 Gew.-% in Isopropanol) direkt in den Arbeitsgasstrom der Plasmaquelle 2 eindosiert. Die Einbringung erfolgte dabei in Form von Aerosol-Tröpfchen mit Hilfe eines Aerosoldosiersystems, wie in EP 2 743 373 B1 beschrieben. Die EP 2 743 373 B1 wird hiermit durch Verweis einbezogen. Hierbei wird der flüssige Precursor mit Hilfe einer Zweistoffdüse zerstäubt und über einen sekundären Gasstrom (ebenfalls Stickstoff) transportiert. Die beiden erstgenannten Precursoren (TTIP, TBO) sind äußerst empfindlich gegenüber Wasser (beispielsweise Luftfeuchtigkeit), was eine zusätzliche Modifikation des Dosiersystems erfordert (zusätzliches Heizen der Schläuche). Weiterhin führt diese Eigenschaft bei direkter Einbringung in den Arbeitsgasstrom zu qualitativ minderwertigen Schichten hinsichtlich Abrasionsbeständigkeit und photokatalytischer Aktivität. Ein Vorteil zeigt sich in diesem Zusammenhang beim Einsatz von TIPO. Dieser Precursor ist deutlich weniger sensitiv gegenüber Luftfeuchtigkeit, wodurch eine Dosierung vereinfacht wurde und ein Verstopfen der Düsen und anderer Bauteile mit geringeren Innendurchmessern reduziert wurde. Ein zusätzliches Heizen der Schläuche ist mit der Verwendung dieses Precursors nicht notwendig. Weiterhin scheint sich dieser Precursor weniger schnell im Plasma umzusetzen, wodurch die exzessive Bildung von groben Partikeln reduziert und damit dichtere sowie stabilere Schichten erzeugt werden konnten. Trotz dieser Verbesserung waren die Schichten vergleichsweise staubig. Die direkte Einbringung der Precursoren in den Arbeitsgasstrom führt zu einer relativ langen Verweilzeit der Precursoren im reaktiven Plasmaraum (Umsetzung der Precursoren und Agglomeration der gebildeten Partikel).

Somit war es zielführend, die Interaktionszeit der Precursoren durch die Verwendung des in mindestens einer der Figuren 1 bis 4 gezeigten und oben beschriebenen Aufsatzes 1 auf ein notwendiges Minimum zu reduzieren.

Zusätzlich zur titanhaltigen Komponente können siliciumhaltige Precursoren eingebracht werden. In den durchgeführten Versuchen wurde Hexamethyldisiloxan (HMDSO) gasförmig über die Verdampfereinheit STS 10.0 der Fa. Sura Instruments GmbH eingebracht. Zur Erzeugung von SiOₓ/TiOₓ-Mischschichten wurde die Menge des eingebrachten HMDSO konstant gehalten, die Menge des titanhaltigen Precursors schrittweise von 0 auf 7,5 µl/min, 15 µl/min und 30 µl/min erhöht. Auch im Zusammenhang mit der Kombination von Precursoren war die Reduktion der Interaktionszeit zielführend und führte zu qualitativ hochwertigeren Schichten.

Aus Zwecken der Vergleichbarkeit wurden für alle Untersuchungen Schichtdicken von etwa 100 nm realisiert. Dafür wurde in Vorversuchen der Einfluss des Abstandes b, der Plasmaleistung, der Precursorkonzentration und der Anzahl der Durchläufe auf die Abscheiderate [nm/Durchlauf] untersucht. Die Verfahrtischgeschwindigkeit, mit der das Substrat 4 unter der Plasmaquelle 2 bewegt wurde, wurde mit 250 mm/s und einem Rasterabstand von 1 mm konstant belassen.

Schichtdickenbestimmungen erfolgten mit einem Alpha-Step D-600 Profilometer (KLA Tencor, Milpitas, USA). In den Untersuchungen wurden Schichten auf Glasobjektträgern (+30 nm Pyrosil-Beschichtung, um mögliche Alkalidiffusion in die Schichten zu vermeiden) und Si-Wafern hergestellt. Alle Substrate wurden zunächst in Isopropanol/Aceton (1:1, V:V) ultraschallgereinigt und mit Druckluft getrocknet. Röntgenphotoelektronenspektroskopische Untersuchungen (XPS) erfolgten mit einem AXIS ULTRA DLD (Kratos Analytical Ltd., Manchester, UK), um die chemische Zusammensetzung der Schichten zu bestimmen. Ellipsometrische Untersuchungen dienten der Bestimmung der Schichtdicke und der Brechzahl der Schichten.

Im folgenden Abschnitt werden ausgewählte Ergebnisse aus Untersuchungen an diesen Mischschichtsystemen dargestellt.

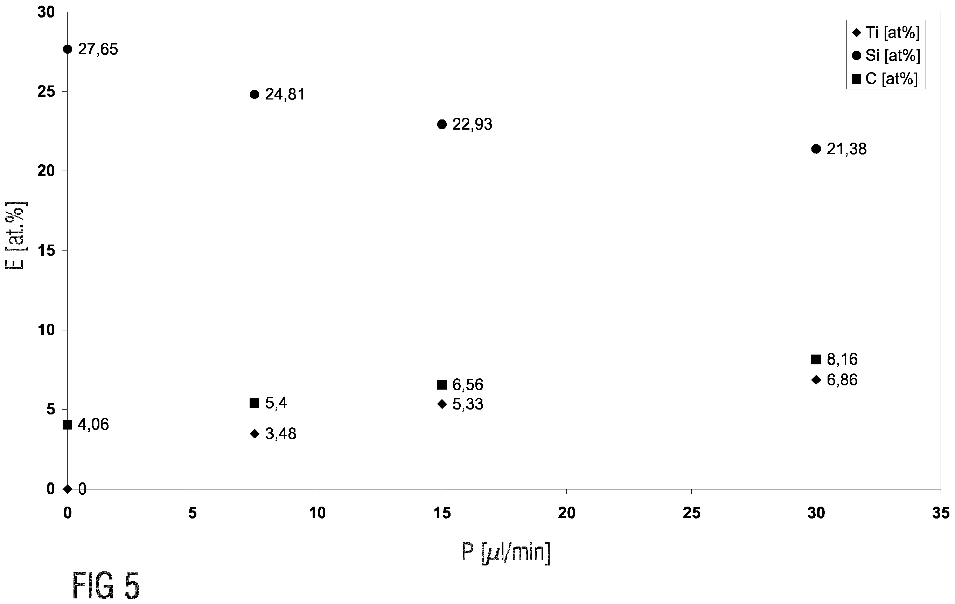

**Figur 5** zeigt ein Diagramm mit der Elementkonzentration E, das heißt der chemischen Oberflächenzusammensetzung der SiOₓ/TiOₓ-Mischschichten in Atom - %, bestimmt mittels XPS, in Abhängigkeit von der Dosiermenge des titanhaltigen Precursors, das heißt des Precursorflusses P in µl/min.

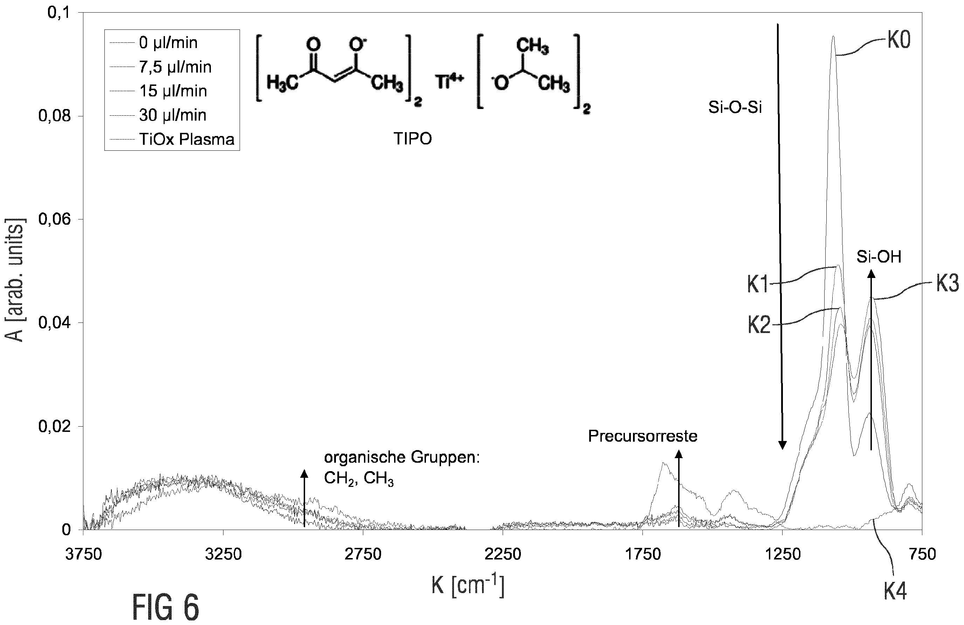

Auf die Darstellung der Sauerstoffkonzentration wird an dieser Stelle verzichtet, da der Fokus auf dem Si/Ti-Verhältnis liegen soll. Der Si-Gehalt, bei der kein titanhaltiger Precursor eingebracht wurde (Precursorfluss P=0), liegt bei etwa 28 Atom-%; Ti ist an dieser Stelle nicht nachweisbar. Mit der Zunahme des titanhaltigen Precursorflusses P steigt die Ti-Konzentration der Schichten an, der Si-Anteil nimmt ab. Gehalte von rund 8 Atom-% Ti konnten durch die Verwendung von 30 µl/min Ti-Precursorfluss P erreicht werden. Auffällig ist weiterhin, dass mit zunehmendem Ti-Anteil der Kohlenstoffanteil der Schichten steigt, was auf nicht umgesetzte Bestandteile des titanorganischen Precursors zurückzuführen ist. Die Annahme, dass zusätzlich Precursorreste des titanhaltigen Precursors in die Schichten eingebettet werden, wird durch FTIR-Messungen (Figur 6) untermauert.

**Figur 6** zeigt die so bestimmten FTIR-Spektren der Mischschichten und reiner SiOₓ (0 µl/min) und TiOₓ Plasmaschichten. Dargestellt ist das Absorptionsvermögen A in Abhängigkeit von der Wellenzahl k in cm⁻¹. Dargestellt sind eine Kurve K0 für einen Precursorfluss P von 0 µl/min, Kurve K1 für einen Precursorfluss P von 7,5 µl/min, Kurve K2 für einen Precursorfluss P von 15 µl/min, Kurve K3 für einen Precursorfluss P von 30 µl/min sowie Kurve K4 für ein reines TiOₓ-Plasma ohne SiOₓ.

Diese Untersuchungen zeigten, dass mit Zunahme des TIPO-Flusses die Bandenfläche zunimmt, welche vor allem auf CH₂ -und CH₃-Schwingungen dieses Precursors zurückzuführen sind [Sigma Aldrich, FTIR-Spektrum]. Zusätzlich lässt sich feststellen, dass der Anteil an Si-O-Si-Schwingungen mit zunehmendem TIPO-Precursorfluss P abnimmt, der Si-OH Anteil aber zunimmt.

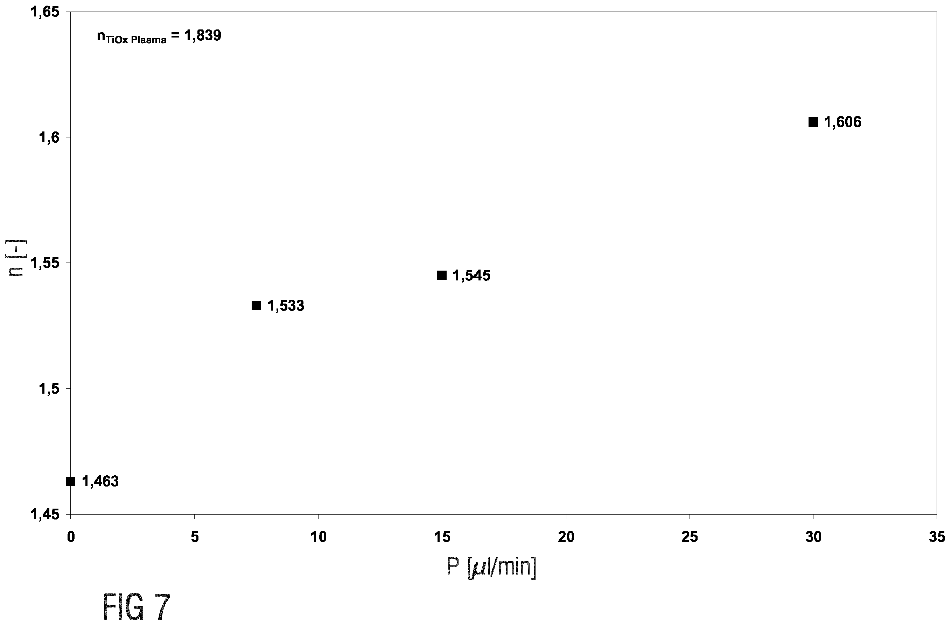

Ellipsometrisch ermittelte Brechzahlen der Schichten werden in **Figur 7** in Abhängigkeit von der TIPO-Dosierrate dargestellt. Dargestellt ist der Brechungsindex n in Abhängigkeit vom Ti-Precursorfluss P. Die titanfreie SiOₓ-Schicht weist eine Brechzahl von rund 1,46 auf. Die Brechzahl n der Schichten nimmt mit zunehmendem Ti-Precursorfluss P zu. Die Brechzahl n für reine TiOₓ Schichten, welche mit dieser Beschichtungsmethode hergestellt wurden, liegt bei rund 1,84. Diese Versuche zeigten, dass es durch die Anpassung des Ti-Precursorflusses P möglich ist, die chemischen Zusammensetzungen und Brechzahlen n der Schichten gezielt zu beeinflussen und/oder einzustellen.

Weiterhin wurde die photokatalytische Aktivität der Beschichtungen mittels Stearinsäure-Abbaus untersucht. Hierbei wurden die FT-IR Transmissionsspektren mit einem MB3000 FT-IR Spektrometer (ABB, Zürich, Schweiz) in einem Wellenzahlbereich von 2000 cm⁻¹ bis 4000 cm⁻¹ und einer spektralen Auflösung von 2 cm⁻¹ untersucht. Stearinsäure ist eine häufig genutzte Modellsubstanz und kommt den Verbindungen nahe, die sich auf natürliche Weise an Oberflächen anlagern. Die Abscheidung der Stearinsäure auf den TiOₓ-Oberflächen erfolgte in einer Vakuumkammer. 7 mg Stearinsäure wurden dabei auf einer Heizplatte positioniert und nach Erreichen des gewünschten Vakuums verdampft. Dieser Präparationsschritt führte zu einer Stearinsäure-Schichtdicke von etwa 100 nm auf der Probenoberfläche. Anschließend wurden die Proben in einem Abstand von 20 cm unter einer Tageslichtlampe (Ultra-VITALUX® sun lamp, OSRAM) für 3 Stunden bestrahlt. Nach 0, 30, 60, 120 und 180 Minuten Bestrahlung wurden FT-IR Spektren im oben genannten Messbereich aufgenommen. Speziell die Banden bei etwa 2800 cm⁻¹ bis 3000 cm⁻¹, welche auf CH₃ und CH₂ Streckschwindungen der Stearinsäure zurückzuführen sind, wurden hierbei untersucht. Bei vorhandener photokatalytischer Aktivität kommt es mit zunehmender Bestrahlungsdauer zur Reduktion der Bandenfläche. Die photokatalytische Aktivität der Schichten wurde dabei mit der Aktivität eines kommerziell erhältlichen Produktes, dem Pilkington Activ® (Nippon Sheet Glass Co. Ltd.) verglichen. Pilkington Activ® besteht aus einer etwa 15 nm dicken Anatas-Schicht auf einem 4 mm Float-Glas. Das Float-Glas ist zusätzlich mit einer etwa 30 nm dicken SiO₂-Schicht versehen, um eine Alkali-Diffusion zu vermeiden [Mills, Andrew, et al. "Photocatalytic oxidation of deposited sulfur and gaseous sulfur dioxide by TiO2 films." The Journal of Physical Chemistry C 111.14 (2007): 5520-5525.].

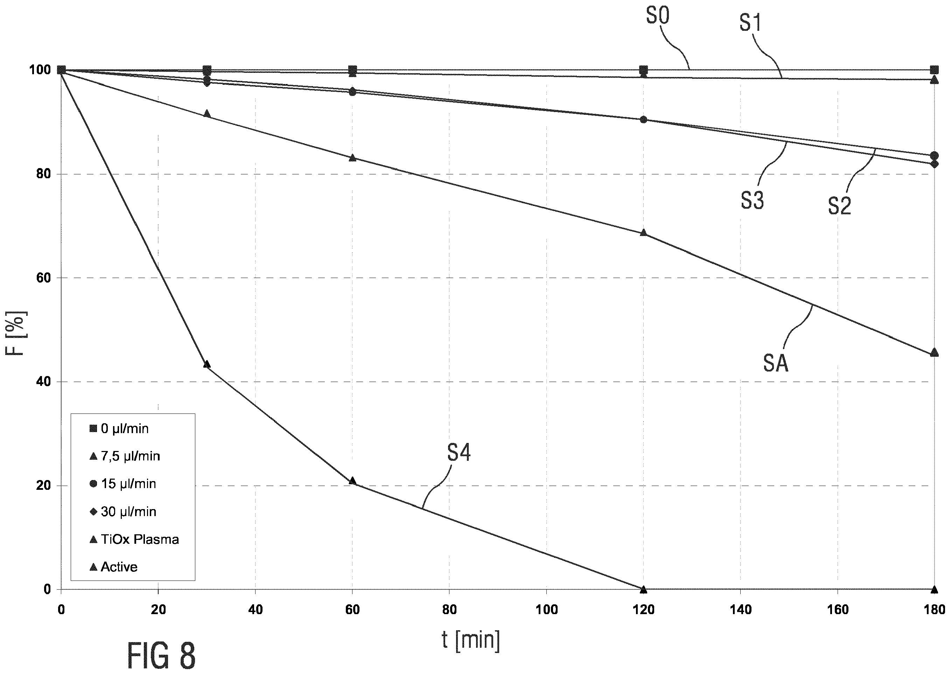

Das Ergebnis dieses Versuchs wird in **Figur 8** dargestellt. Im Diagramm werden die relativen Bandenflächen F aus FTIR-Messungen in Abhängigkeit von der Bestrahlungszeit t dargestellt. Hierbei sind die Ausgangsbanden auf 100% normiert und die Bandenflächen nach 30, 60, 120 und 180 min Bestrahlung werden entsprechend auf den Ausgangswert bezogen. Eine Reduktion des relativen Wertes zeigt damit die photokatalytische Eigenschaft der Schichten. Die titanfreie SiOₓ-Schicht S0 (0 µl/min) zeigte keine Reduktion der Bandenfläche der Stearinsäure, wodurch dieser Schicht keine photokatalytische Aktivität zuzusprechen ist. Mit zunehmendem Ti-Gehalt der Schichten S1 (7,5 µl/min), S2 (15 µl/min), S3 (30 µl/min) und S4 (reine TiOₓ-Plasmaschichten) steigt die photokatalytische Aktivität an. Die Mischschicht S3, welche mit dem höchsten TIPO-Fluss hergestellt wurde (30 µl/min), zeigte die höchste Aktivität und bewirkte eine Reduktion der Bandenfläche um etwa 20 % nach 180 min Bestrahlung. Im Vergleich dazu wurden bei siliciumfreien TiOₓ-Plasmaschichten S4 bereits nach 120 min keine Stearinsäure mehr nachgewiesen. Damit war eine deutliche Reduzierung der photokatalytischen Aktivität durch das Mischen mit SiOₓ zu beobachten. Die Kurve SA stellt die photokatalytische Aktivität der Schicht des kommerziell erhältlichen Produktes Pilkington Activ® dar.

### Beispiel II (SiOₓ/SnOₓ-Mischschichten)

Als weiteres Ausführungsbeispiel wurden Siliciumoxid/ Zinnoxid/- Mischschichten hergestellt. Hierbei wurden analog zur Herstellung der Siliciumoxid/ Titanoxid-Mischschichten anstelle des titanhaltigen Precursors (TIPO) der zinnorganische Precursor Tetrabutylzinn (TBT) unter Verwendung des oben beschriebenen Aufsatzes 1 eingebracht.

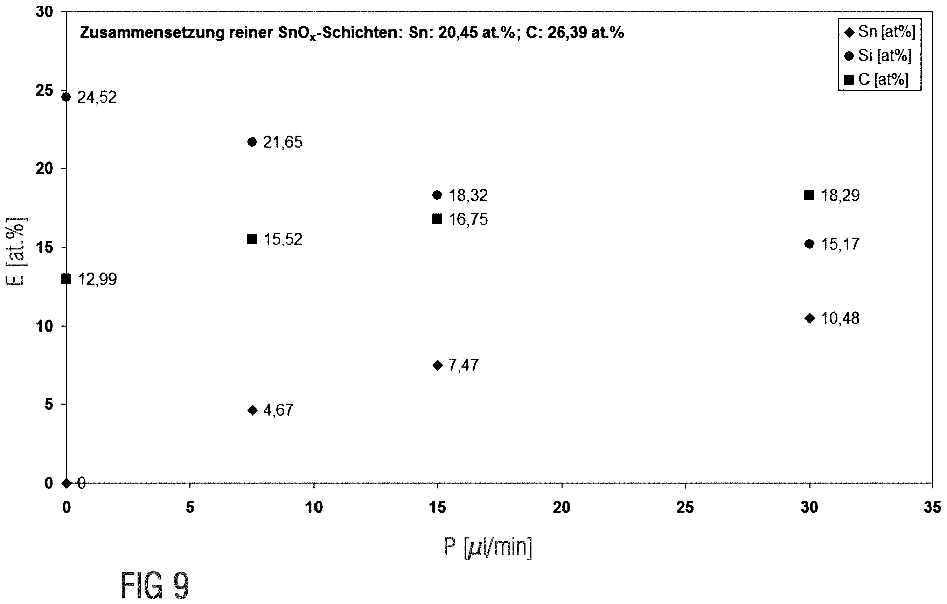

Untersuchungen mittels XPS zeigten ebenfalls die Möglichkeit auf, derartige Mischschichtsysteme herzustellen. In **Figur 9** wird die Schichtzusammensetzung in Abhängigkeit vom TBT-Precursorfluss dargestellt. Dargestellt ist die Elementkonzentration E in Abhängigkeit vom TBT-Precursorfluss P.

Vergleichbar mit der Zusammensetzung der Siliciumoxid/Titanoxid/ - Mischschichten lässt sich für dieses Schichtsystem ein zunehmender Zinngehalt mit der Erhöhung des TBT-Precursorflusses P feststellen. Deutlich ist ebenfalls die Zunahme des Kohlenstoffgehaltes der Schichten, was auf nicht umgesetzte Precursorbestandteile (vor allem des TBT) zurückzuführen ist. Vor allem für die SnOₓ-Schicht ist dieser Anteil relativ hoch. Dies deutet darauf hin, dass die Plasmaenergie im Beschichtungsprozess zu gering ist, um den Precursor vollständig umzusetzen. Optional wäre in diesem Fall eine Erhöhung des Abstandes b für den zinnorganischen Precursor TBT, das Beheizen des Substratmaterials oder ein anschließender Wärmebehandlungsschritt möglich, um noch vorhandene Precursorreste zu verringern oder zu entfernen. Auch die Verwendung von Plasmaquellen 2 höherer Leistung könnte zur besseren Umsetzung des Precursors zielführend sein.

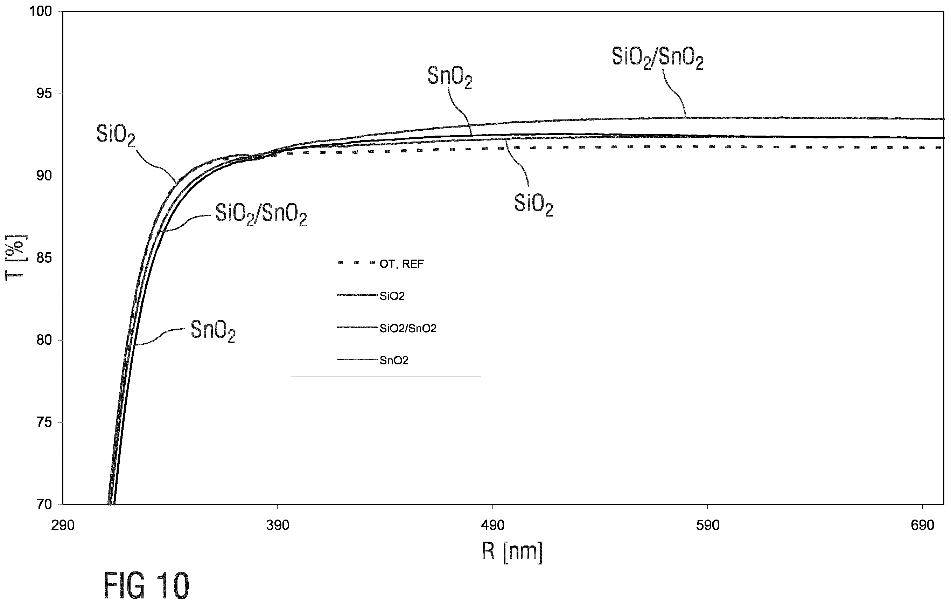

Zusätzlich wurden UV/VIS-Spektren der Schichten auf Glassubstraten in Transmission aufgenommen, welche in **Figur 10** dargestellt sind. Gezeigt ist die Transmission T in Abhängigkeit von der Wellenlänge λ. Mit Zunahme des Sn-Gehaltes der Schichten verschiebt sich die Absorptionskante zu höheren Wellenlängen. Weiterhin zeigt sich hier für die Mischschichten eine Transmissionserhöhung ab etwa 390 nm Wellenlänge für die Mischschichten. Die gepunktete Kurve stellt in diesem Diagramm das Transmissionsspektrum eines unbeschichteten Glasobjektträgers dar.

### Beispiel III: TiOₓ-Plasmaschichten

In den im Beispiel I beschriebenen Versuchen zeigten vor allem die siliciumfreien TiOₓ-Beschichtungen hervorragende photokatalytische Eigenschaften. Überraschenderweise konnte festgestellt werden, dass diese sehr gute photokatalytische Aktivität ohne ein Beheizen des Substrates (Substrattemperatur 18-25°C) und ohne eine thermische Nachbehandung erzielbar ist, in Verbindung mit einer guten Transparenz der Schichten. Es erfolgt lediglich ein geringer Temperatureintrag über die Plasmaenergie in das Substratmaterial, sodass auch eine Beschichtung temperatursensibler Materialien (z. B. Kunststoffe, Fasern oder Textilien) möglich wird.

Im folgenden Abschnitt soll deshalb noch einmal näher auf die photokatalytischen Eigenschaften solcher Schichten in Abhängigkeit verschiedener Anlagenparameter eingegangen werden.

Zur Abscheidung qualitativ hochwertiger Schichten war es vorteilhaft, die Precursoren möglichst substratnah einzudosieren (unter Verwendung des beschriebenen Aufsatzes 1). In Versuchen, bei denen dieser Precursor weiter entfernt vom Substrat eingebracht wurde, konnte lediglich eine staubartige Bedeckung der Substratoberfläche erreicht werden, welche weder abrasionsbeständig noch photokatalytisch aktiv war.

Es wurden TiOₓ-Schichten mit den in Tabelle 2 angegebenen Prozessparametern hergestellt.

**Tabelle 2: Prozessparameter Titanoxid: Vergleich Plasmaleistung**

| **Prozessparameter** | **Einheit** | **Wert** |
|---|---|---|
| Plasmaleistung | [W] | 300 W, 600 W |
| Arbeitsgas | [-] | Stickstoff |
| Verfahrgeschwindigkeit | [mm/s] | 25 mm/s |
| Anzahl Durchläufe (Schichtdicke etwa 100 nm) | [-] | 3 |
| Abstand a | [mm] | 20 |
| Abstand b | [mm] | 5 |

| **Parameter Precursordosierung** | | |
|---|---|---|
| Precursorkonzentration | [Gew.-%] | 50 |
| Precursorfluss Mikrodosierpumpe | [µl/min] | 25 |
| Zweistoffdüsendruck | [bar] | 4,5 |

Mittels rasterelektronenmikroskopischer Untersuchungen an Bruchkanten der abgeschiedenen Schichten wurde speziell der Einfluss der Plasmaleistung auf die Schichteigenschaften untersucht. Dabei ergab sich, dass niedrige Leistungen generell zu glatten und homogenen Schichten führen. Der Einsatz hoher Leistungen führt im Vergleich dazu zu raueren Schichten und gröberen Partikeln auf der Oberfläche, aber dennoch zu einem homogenen Beschichtungsbild. Der Einsatz der niedrigeren Leistung führte allerdings zur Bildung wenig stabiler Beschichtungen, wodurch nach 1000 Waschzyklen (Washability Test, nach ASTM D2486) keine Beschichtung auf der Substratoberfläche mehr nachweisbar war. Eine photokatalytische Aktivität der bei 300 W Leistung hergestellten Schicht war zudem nicht nachweisbar bzw. nicht vorhanden. Die bei 600 W abgeschiedenen Schichten hingegen zeigten lediglich einen relativen Schichtdickenverlust von ∼25% nach 1000 Zyklen, was auf die Entfernung von losen Partikeln auf der Oberfläche zurückzuführen sein kann. Weiterhin konnten sehr gute photokatalytische Eigenschaften nachgewiesen werden, welche mit der photokatalytischen Wirkung des Pilkington Activ® vergleichbar und zum Teil besser sind (Ergebnisse in nachfolgenden Abschnitten dargestellt). Demzufolge wurden nachfolgende Untersuchungen bei Plasmaleistungen von 600 W durchgeführt.

In weiteren Untersuchungen wurde der Einfluss des Abstandes b und der Precursorkonzentration auf die Dicke, Morphologie, optische Eigenschaften, photokatalytische Aktivität und Abriebbeständigkeit der Schichten untersucht. Dabei wurde der Abstand b zwischen 2 mm und 9 mm variiert. Mit abnehmender Precursorkonzentration wurde die Anzahl an Beschichtungsdurchläufen entsprechend erhöht, um eine finale Schichtdicke von etwa 100 nm zu realisieren (Schichtabscheidungsrate ermittelt in vorangegangenen Schichtdickenmessungen).

Es wurden rasterelektronenmikroskopische Untersuchungen an Bruchkanten der abgeschiedenen TiOₓ-Beschichtungen durchgeführt, welche mit Konzentrationen von 50, 25 und 12,5 % und Abständen b von 2 mm und 5 mm hergestellt wurden. Mit zunehmendem Abstand b erhöht sich die Anzahl an groben Partikeln an der Oberfläche. Ein ähnlicher Trend kann mit abnehmender Precursorkonzentration beobachtet werden. Vor allem bei Konzentrationen von 25 % und 12,5 % und Abstand b von 5 mm konnten Schichten mit sehr dichter Partikelkonzentration an der Oberfläche hergestellt werden, also Schichten mit hoher spezifischer Oberfläche. Diese Beobachtung deckt sich mit rasterelektronenmikroskopischen Untersuchungen von Draufsichten auf die Schichten. Durch die Erhöhung des Abstandes b erhöht sich die Interaktionszeit des Precursors mit dem Plasma. Dies kann zum einen zu einer vollständigeren Umsetzung des Precursors zu TiOₓ, zum anderen aber auch zur Bildung größerer Partikel und deren Agglomeration führen. Wird der Abstand weiter auf 7 oder 9 mm erhöht, entstehen lediglich noch staubigere Schichten, welche weder im Ultraschallbad noch im Washability-Test beständig sind. Somit sollten zur Erzeugung haftfester Schichten Abstände b kleiner als 7 mm gewählt werden.

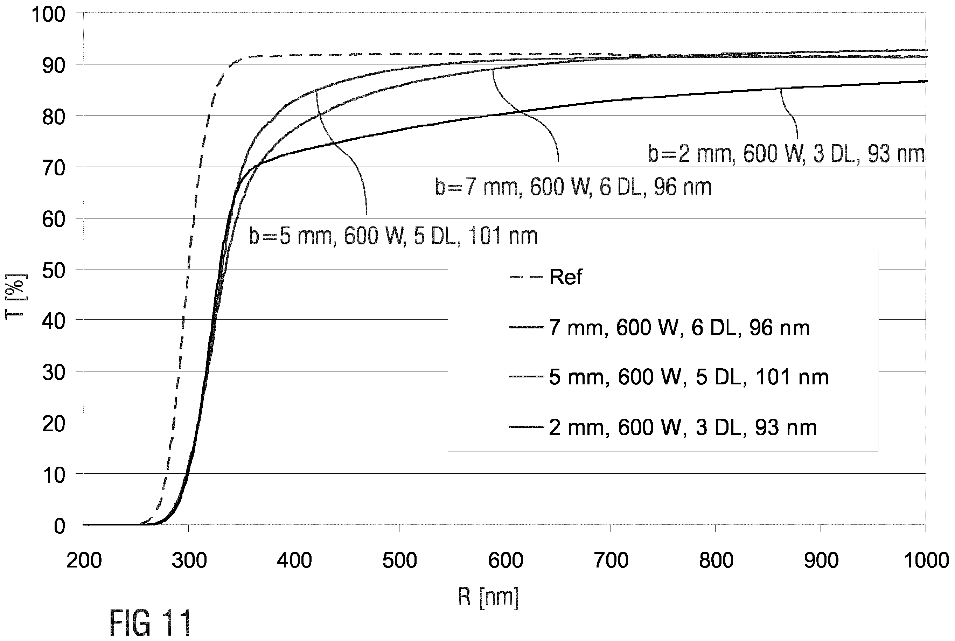

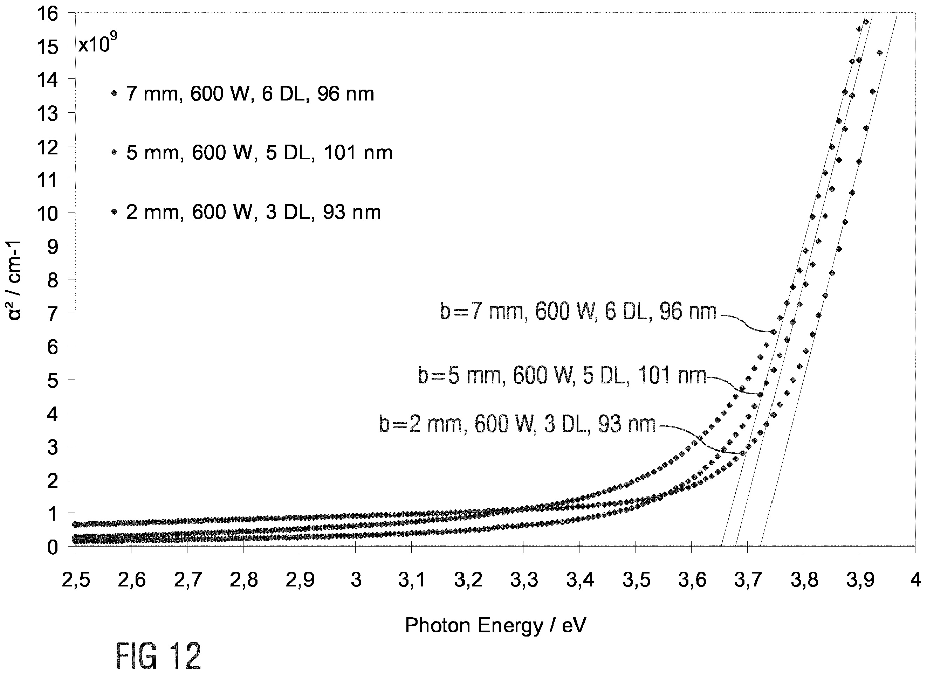

Die UV-Vis Transmissionsspektren werden beispielhaft für Schichten in **Figur 11** gegenübergestellt, die unter Verwendung des 25 %-igen Precursors und unterschiedlichen Abständen b hergestellt wurden. Dargestellt ist der Transmissionsgrad T in Abhängigkeit von der Wellenlänge λ. Weiterhin wurden aus diesen Spektren die Bandlücken E_{g} bestimmt, die in **Figur 12** gezeigt sind, wobei α der optische Absorptionskoeffizient ist. Es konnte beobachtet werden, dass mit zunehmendem Abstand b und damit der Erhöhung der Interaktionszeit zwischen Plasma und Precursor die Bandlücke von 3,73 eV auf 3,65 eV reduziert wird. Dies könnte weiterhin auf die erhöhte Durchlaufanzahl, also auf einen erhöhten Energieeintrag durch das Plasma zurückzuführen sein (um eine Schichtdicke von etwa 100 nm zu realisieren) oder auch durch Veränderungen in der Schichtstruktur.

Aus [Hong, Yong Cheol, et al. "Band gap narrowing of TiO2 by nitrogen doping in atmospheric microwave plasma." Chemical Physics Letters 413.4 (2005): 454-457.] ist bekannt, dass es durch den Einsatz von stickstoffhaltigen Plasmen möglich ist, TiOₓ-Schichten mit Stickstoff zu dotieren. In dieser Publikation konnten so mittels Sol-Gel-Prozess hergestellte Schichten über eine Plasmaentladung im Niederdruck dotiert werden. Derartige Dotierungen können den Vorteil haben, dass photokatalytische Effekte auch oder zusätzlich durch die Bestrahlung mit sichtbarem Licht initiiert werden, was die Effektivität der Beschichtung steigern kann.

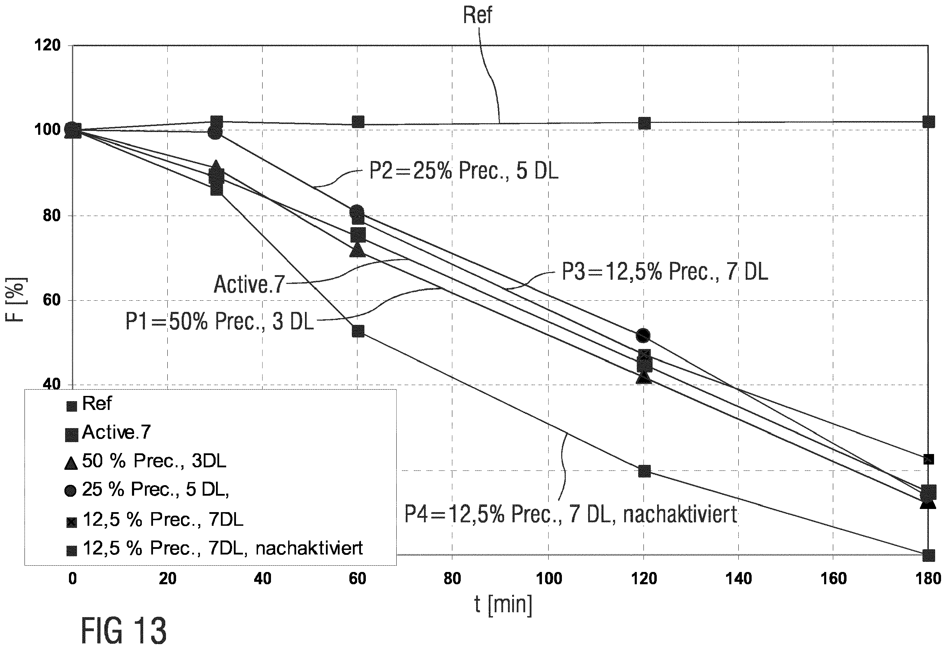

An dieser Stelle sollen ausgewählte Untersuchungen der photokatalytischen Aktivität der Beschichtungen gezeigt werden. In einem Beispiel soll der Einfluss einer Stickstoffplasma-Nachaktivierung im Vergleich zu nicht nachaktivierten Beschichtungen gezeigt werden (**Figur 13**). Wie dem Diagramm zu entnehmen ist, bewirkte eine unbeschichtete Glasprobe Ref keinen Abbau der Stearinsäure bzw. keine Reduktion der CH₂ und CH₃ Bandenfläche. Deutliche Wirkungen zeigten die Pilkington Activ® Oberfläche (Active. 7) und die mittels Plasma-Jet hergestellten Proben P1, P2, P3. Die Wirkungen der TiOₓ-Schichten waren in diesem Test vergleichbar und es konnte nach 3 Stunden Bestrahlung ca. 85 % der Stearinsäure abgebaut werden. P4 stellt die Wirkung der nachaktivierten Proben dar. Diese wirkten im Test wesentlich besser und keine Stearinsäure konnte nach 3 Stunden Bestrahlung mehr nachgewiesen werden.

### Beispiel IV: SiOₓ-Beschichtungen

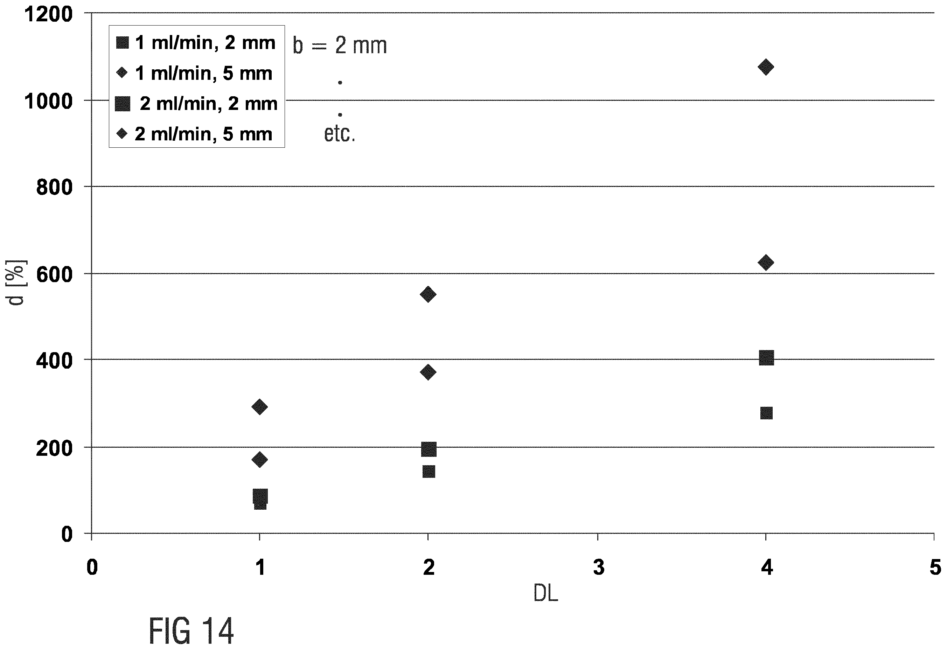

Neben titanhaltigen Precursoren wurden die siliciumorganischen Precursoren HMDSO (eindosiert über eine Verdampfereinheit, beispielsweise der STS 10.0 - Sura Instruments GmbH) und TEOS (eindosiert über das Aerosol Dosiersystem aus EP 2 743 373 B1) zur Schichtabscheidung mit dem Aufsatz 1 verwendet. Auch bei der Abscheidung von quarz-ähnlichen Schichten kommt es mit steigender Schichtdicke zur Bildung gröberer Partikel auf der Oberfläche, was die maximal erreichbare Schichtdicke d und damit mögliche Einsatzzwecke einschränkt. Somit konnte auch hier die Bildung gröberer Partikel durch substratnähere Eindosierung des Precursors (über den beschriebenen Aufsatz) vermieden und dickere Schichten erzeugt werden. Im Falle dickerer Schichten können folglich auch höhere Konzentrationen an neuen Funktionalitäten (antimikrobielle Wirkstoffe, Farbstoffe, hydrophobe Substanzen, Polymere, Flammschutzmedien, UV-Schutzmedien, photokatalytische oder magnetische Partikel, Kohlenstoffnanoröhren, Nanopartikel wie Quantum Dots, Carbon Dots, Graphen) in die SiOₓ-Matrixschichten eingebracht werden, die nicht zwingend oxidischen Ursprungs sein müssen, wie im Falle der Beispiele I (SiOₓ/TiOₓ) und II (SiOₓ/SnO). Zunächst wurden in ersten Versuchen reine SiOₓ-Schichten betrachtet (**Figur 14**), die mit HMDSO als Precursor hergestellt wurden. Dargestellt ist die Schichtdicke d in nm in Abhängigkeit von der Anzahl DL der Durchläufe der Beschichtung. Für die nachfolgend dargestellten Ergebnisse sind die Beschichtungsparameter aus Tabelle 3 zu entnehmen. Der Beschichtungsprozess ist aber nicht auf diesen Parameterbereich beschränkt (siehe Tabelle 1).

**Tabelle 3: Prozessparameter Siliziumoxid**

| **Prozessparameter** | **Einheit** | **Einstellbereich** |
|---|---|---|
| Plasmaleistung | [W] | 600 |
| Arbeitsgas | [-] | Stickstoff |
| Verfahrgeschwindigkeit | [mm/s] | 25 |
| Anzahl Durchläufe | [-] | 1 bis 4 |
| Abstand a | [mm] | 20 |
| Abstand b | [mm] | 2 bis 5 |
| Precursorfluss siliziumorganischer Precursor (Hexamethyldisiloxan → Verdampfereinheit) | [ml/min] | 1 bis 2 |

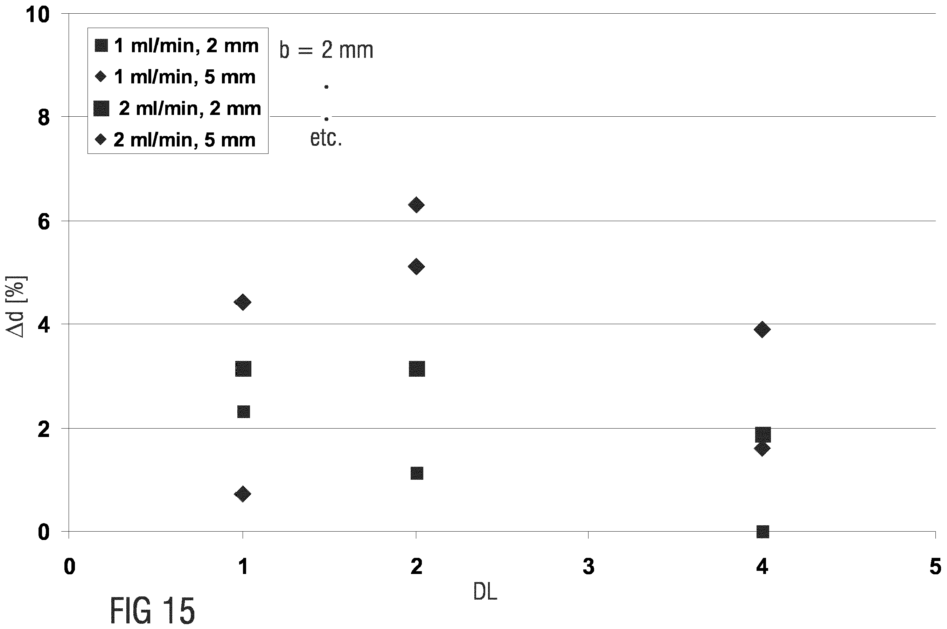

Es können je nach Dosierrate und Durchlaufanzahl unterschiedlich dicke Schichten realisiert werden. Generell steigt mit der Dosierrate, der Anzahl DL an Durchläufen und dem Abstand b die Schichtdicke an. In diesen Versuchen konnten überraschenderweise Schichten im Bereich von bis zu 1 µm hergestellt werden, welche trotz dieser sehr großen Schichtdicken mechanisch stabil sind (4% Schichtdickeverlust Δd nach 1.000 Washability-Zyklen, siehe **Figur 15**). Im Vergleich dazu ist es mit herkömmlichen Precursordosierungen nicht möglich, derartig dicke Schichten mechanisch stabil zu realisieren.

Es ist zu erwarten, dass mit diesem entwickelten Aufsatz eine Vielzahl zusätzlicher Schichten, Schichtstöchiometrien und/oder Funktionalitäten erzielt werden können:
- Einsatz temperatursensibler Precursoren, die durch die Variation der Interaktionszeit im Plasma besser verarbeitet werden können (z. B. für Polymerschichten, Polymer-Mischschichten, DLC-Schichten, hydrophobe Schichten und weitere kohlenstoffbasierte Schichtsysteme)
- Erzeugung weiterer Metall- und/oder Halbleiter- und/oder Nichtmetallbasierter Oxidschichten auf Basis von z. B. Si, Ti, Sn, Zn, Al, Zr, W, Li, Na, Mg, Co, Mn, In, Sb, Ce, Y, Fe, Ni, V, Mo, Nb, Te, Cu, Ba, Ca, P, S, C, N, F;
- Erzeugung von Metalloxid-Mischschichten und/oder Metalloxid/Halbleiteroxid-Mischschichten und/oder Metalloxid/Nichtmetalloxid-Mischschichten und/oder Halbleiteroxid/Nichtmetalloxid-Mischschichten, bspw. SiOₓ/TiOₓ, SiOₓ/SnOₓ, YIG (yttrium iron garnet), YAG (yttrium aluminium garnet), LiCoO₂, LiFePO₄ oder weitere Mischungen der obengenannten Elemente
- Realisierung von Metalloxid/Polymer-Mischschichten, Halbleiteroxid/Polymer-Mischschichten und Kompositschichten, bestehend aus einer Matrixschicht, die mit Partikeln (z. B. antimikrobielle Wirkstoffe, Farbstoffe, hydrophobe Substanzen, Polymere, Flammschutzmedien, UV-Schutzmedien, photokatalytische oder magnetische Partikel, Kohlenstoffnanoröhren, Nanopartikel wie Quantum Dots, Carbon Dots, Graphen) beladen ist
- Erzeugung von Hartstoffschichten wie Nitride oder Carbide
- Phosphatschichten (wie z. B. Magnesiumphosphat, Zinkphosphat, Eisenphosphat) als Korrosionsschutzschichten oder direkte Konversionsschichten an metallischen Bauteiloberflächen bei Verwendung von Phosphorsäure oder Triethylphosphat.

Mit dem Aufsatz 1 und dem beschriebenen Verfahren ist die Realisierung von Mischschichten möglich durch zeitgleiches substratnahes Eindosieren mehrerer (1 + n) chemischer Vorläufersubstanzen (Precursoren) über eine Anordnung mehrerer Düsen (5) (Anzahl = 1 + n)
∘ Durch Variation der Precursorkonzentration, Flussraten, Verhältnisse lassen sich die Metalloxid-Konzentrationen in den Schichten (z. B. Si-Oₓ, TiOₓ, SnOₓ) von 0% bis 100% einstellen.
∘ Der Aufsatz 1 für Plasmasysteme erlaubt die gleichzeitige Eindosierung von mehreren Precursoren (gasförmig, flüssig -> Aerosole, Feststoffe - in Flüssigkeiten dispergiert und Pulver -> ebenso Aerosole), auch an unterschiedlichen Punkten im Plasma oder in der Nähe, durch Variation des Abstandes b für jede Düse 5. Weiterhin ist es denkbar, die Presursoren auch außermittig zum Plasmastrahl einzudosieren als zusätzliche Einstellgröße.
∘ Dadurch ist eine gezielte Einstellung der Plasma-Precursor Interaktionszeit für jede Precursorsubstanz gegeben für eine optimale Umsetzung und daraus resultierenden Schichteigenschaften.

Im Falle von siliciumfreien TiOₓ-Plasmaschichten (100% TiOₓ und 0% SiOₓ) abgeschieden mit dem Aufsatz 1, zeigt sich überraschenderweise eine sehr gute photokatalytische Aktivität ohne Heizen des Substrates und ohne thermische Nachbehandlung.
∘ kein zusätzliches Temperieren der Substrate notwendig → Substrattemperaturen 18 °C bis 25 °C)
∘ Es erfolgt lediglich ein geringer Temperatureintrag über die Plasmaenergie in das Substratmaterial, so dass auch eine Beschichtung temperatursensibler Materialien (z. B. Kunststoffe, Fasern oder Textilien) möglich wird.
∘ Das Einbringen des titanhaltigen Precursors TIPO als Aerosol in das Plasma ist ohne Heizen der Aerosoldosiereinheit und Schläuchen möglich. Daraus ergibt sich ein hohes Anwendungspotential und gute Wirtschaftlichkeit für den gesamten Beschichtungsprozess.
∘ Eine Dotierung der Schichten durch Plasmanachaktivierung ist möglich (z. B. Stickstoffdotierung bei Verwendung folgender Arbeitsgase oder - gasgemische: N₂, Ar/N₂, He/N₂, N₂/H₂, N₂/NH₃) oder Kohlenstoffdotierung bei Verwendung von CO₂, Ar/CO₂, Ar/C₃H₈, Ar/C₂H₂).

Im Falle von titanfreien SiOₓ-Plasmaschichten (100% SiOₓ und 0 % TiOₓ) abgeschieden mit dem Aufsatz 1, sind transparente Schichten bis in den µm-Schichtdickenbereich bei überraschenderweise gleichzeitig sehr guter Abrasionsbeständigkeit möglich.

Das Plasma-Jet-System verwendet bevorzugt Luft oder Stickstoff als Arbeitsgas, kann aber auch mit Edelgasen (z. B. Argon, Helium), wasserstoffhaltigen Gasen oder anderen Gasgemischen betrieben werden.

### BEZUGSZEICHENLISTE

- 1: Aufsatz
- 2: Plasmaquelle
- 3: Schelle
- 4: Substrat
- 5: Düse
- 6: Arm
- a: Abstand
- A: Absorptionsvermögen
- b: Abstand
- d: Schichtdicke
- DL: Anzahl Durchläufe
- Δd: Schichtdickenverlust
- E: Elementkonzentration
- E_{g}: Bandlücke
- F: Bandenfläche
- k: Wellenzahl
- K0: Kurve
- K1: Kurve
- K2: Kurve
- K3: Kurve
- K4: Kurve
- λ: Wellenlänge
- n: Brechungsindex
- P: Precursorfluss

- P1: Probe
- P2: Probe
- P3: Probe
- P4: Probe
- Ref: unbeschichtete Glasprobe
- SA: Kurve
- S0: Schicht
- S1: Schicht
- S2: Schicht
- S3: Schicht
- S4: Schicht
- t: Bestrahlungszeit
- T: Transmission
- ω: Winkel

## Patentansprüche

1. Aufsatz (1) für eine Plasmaquelle (2) zur Dosierung von Precursoren, umfassend mindestens eine Düse (5), die an der Plasmaquelle (2) befestigt oder anderweitig in einer festen Position zur Plasmaquelle (2) anordenbar ist, derart, dass ein aus der Düse (5) ausströmender Precursor einem aus der Plasmaquelle (2) austretenden Plasmastrahl unter einem vorgegebenen Winkel (ω) sowie mit einem in einem Bereich von 0,5 mm bis 10 mm einstellbaren vorgegebenen Abstand (b) zwischen einer Austrittsöffnung der Düse (5) und einem zu beschichtenden Substrat (4) zuführbar ist.

2. Aufsatz (1) nach Anspruch 1, wobei ein Abstand (a) zwischen einer Austrittsöffnung der Plasmaquelle (2) und dem Substrat (4) und/oder der Winkel (ω) einstellbar ist.

3. Aufsatz (1) nach einem der Ansprüche 1 oder 2, wobei mindestens zwei Düsen (5) vorgesehen sind.

4. Aufsatz (1) nach Anspruch 3, wobei die mindestens zwei Düsen (5) unabhängig voneinander bezüglich des Abstands (b) und/oder des Winkels (ω) einstellbar sind.

5. Verfahren zur Herstellung einer Schicht auf einem Substrat (4), wobei in der Nähe des Substrats (4) mindestens ein Precursor über einen Aufsatz (1) nach einem der vorhergehenden Ansprüche in oder in die Nähe eines aus einer Plasmaquelle (2) austretenden Plasmastromes eindosiert wird.

6. Verfahren nach Anspruch 5, wobei eine Oxidschicht, eine Nitridschicht, eine Carbidschicht, eine Phosphatschicht, eine Polymerschicht, oder durch Eindosieren mehrerer Precursoren in oder in die Nähe des Plasmastroms eine Metalloxid-Mischschicht, eine Metalloxid/Halbleiteroxid-Mischschicht, eine Metalloxid/Nichtmetalloxid-Mischschicht, eine Halbleiteroxid/Nichtmetalloxid-Mischschicht, eine Polymer-Mischschicht, eine Metalloxid/Polymer-Mischschicht, eine Halbleiteroxid/Polymer-Mischschicht oder eine Kompositschicht bestehend aus einer Matrixschicht die mit Partikeln beladen ist abgeschieden wird.

7. Verfahren nach einem der Ansprüche 5 oder 6, wobei die Precursoren dem Aufsatz (1) in Form eines Gases oder Gasgemisches, als Aerosol oder in Feststoffform zugeführt werden.

8. Verfahren nach einem der Ansprüche 5 bis 7, wobei mittels des Aufsatzes ein Abstand (b) zwischen einer Austrittsöffnung der Düse (5) und einem zu beschichtenden Substrat (4) in einem Bereich von 0,5 mm bis 10 mm eingestellt wird.

9. Verfahren nach einem der Ansprüche 5 bis 8, wobei Luft oder Stickstoff als Arbeitsgas für die Plasmaquelle verwendet werden.

10. Verfahren nach einem der Ansprüche 5 bis 9, wobei eine Temperierung des Substrates während des Beschichtungsprozesses und/oder eine anschließende Wärmebehandlung erfolgt oder unterbleibt.

11. Bauteil, umfassend eine Oberfläche, die mittels des Verfahrens nach einem der Ansprüche 5 bis 10 mit einer photokatalytisch aktiven TiOₓ - Schicht oder SiOₓ / TiOₓ-Mischschicht beschichtet ist.

12. Bauteil, umfassend eine Oberfläche, die mittels des Verfahrens nach einem der Ansprüche 5 bis 10 mit einer Yttrium-Eisen-Granat oder Yttrium-Aluminum-Granat oder SnOₓ - Schicht oder SiOₓ - Schicht oder SiOₓ / SnOₓ - Mischschicht beschichtet ist.

13. Bauteil, umfassend eine Oberfläche, die mittels des Verfahrens nach einem der Ansprüche 6 bis 10 mit einer optisch transparenten SiOₓ / TiOₓ oder SiOₓ / SnOₓ Mischschicht beschichtet ist, wobei eine Brechzahl oder ein Brechzahlgradient über die Schichtdicke durch Variation des Mischungsverhältnisses zweier eindosierter Precursoren gezielt einstellbar ist.
